# EUROPEAN PATENT APPLICATION

(11) **EP 3 098 674 A1**
(43) Date of publication of application: **30.11.2016**
(21) Application number: 15425039.3
(22) Date of filing: 28.05.2015
(51) Int. Cl.: G05B 19/05, G05B 19/418, G06Q 10/08, B65G 1/02, H01L 21/67, B65G 43/00

(54) **METHOD IMPLEMENTED BY A PROCESSOR FOR THE MOVEMENT OF CONTAINERS OF SEMI-FINISHED PRODUCTS AND RELATED APPARATUS**

(71) Applicant: Anzani Machinery SRL, 20015 Parabiago (MI) (IT)
(72) Inventor: Anzani, Lanfranco, 20015 Parabiago (MI) (IT)
(74) Representative: Lecce, Giovanni

(57) **Abstract**

A method (100) for the movement of containers of semi-finished products on automated systems comprises the steps of:
- checking containers (102) entering the storage area;
- code reading (104) and opening the storage area;
- storage (108) of the position and of the storage area of disposition of the container;
- availability check (110) of the storage area;
- checking containers being requested (112) by the workstations PL;
- extracting container (122) and sending to the requesting workstation PL;
- checking further containers being requested (124) by the workstations PL;

and comprising the further steps of:
- selection criterion (116) for sending containers;
- assignment of a score (118) of the container code;
- one or more checking steps (106, 120) of the score of the container code that is higher than the others.

The invention also comprises an apparatus that implements said method (100).

## Description

This invention relates to a method implemented by a processor for the movement of containers of semi-finished products and related apparatus.

More particularly, this invention relates to a method implemented by a processor or computer for the management and movement of containers of semi-finished materials, and to the related apparatus that implements said method, especially for plants for the continuous production of manufactured articles or components be assembled, made of leather, hides or synthetic materials.

Industrial plants are known for the mass production of various kinds of semi-finished products, such as, for example, footwear or clothing. These plants, developed on one or more adjacent processing lines, include multiple workstations for as many operators, each of which performs a specific action on the semi-finished products. A certain number of components is grouped in appropriate containers that, arranged on a movement line, are moved through the various workstations and then subsequently conducted, by means of ramps, conveyor belts, column elevators, etc., to stations for the temporary storage or sorting of the containers themselves. Said container storage stations can be realized and arranged in various types of structures that are usually advantageously realized on a surface raised above the processing line in such a way as to minimize the overall dimensions of the plant. When they are required, said containers are retrieved from the storage stations and are transferred again on the line, sliding by gravity on descending sections of roller conveyors, through conveyor belts or column elevators, to reach the processing line for the subsequent steps of processing or assembly.

Said production plants are generally managed automatically by a control unit comprising one or more PLCs (*Programmable Logic Controllers*) that have the function of coordinating and managing the entire movement of the containers entering and exiting the production line and their access to the storage stations, receiving signals from sensors disposed on the line and controlling the servomotors that actuate the various parts of the plant. Said plants are also equipped with known systems for labelling of containers entering the storage area, generally of the optical or electromagnetic type, in such a way that the control unit is aware of which and how many containers are disposed in the storage area.

On medium and large plants with multiple processing stations different from each other, the need arises to create long sections of line, generally by means of conveyor belts, with a large variety of different containers handled along the line and containing semi-finished products relating to different types of production, different parts or different stages of progress of processing. This entails many drawbacks, including a greater complexity of managing the movement and the recognition of various containers, a non-rational and non-efficient arrangement of the different containers in the storage areas, which are reached at random, drawbacks such as to entail long times for the movement and delivery of the containers and a low flexibility and adaptability of the production plant to substitute variations of the type or quantity of the product.

The purpose of this invention is to overcome the drawbacks listed above.

More particularly, the purpose of this invention is to provide a method implemented by a processor for the movement of containers of semi-finished products and the related apparatus able to appreciably reduce the movement times of the same containers, making the operations of entering and exiting the storage area faster.

A further purpose of this invention is to provide a method implemented by a processor for the movement of containers of semi-finished products and the related apparatus able to optimize the arrangement of the containers in storage areas in such a way as to make immediately available the containers required by one or more production lines without the idle circulation of the containers.

A still further purpose of the invention is to make available to users a method implemented by a processor for the movement of containers of semi-finished products able to control the processing times of each workstation and to compare them with standard times, in such a way as to determine the operating yield of each container and each operator.

A further purpose of the invention is to make available to users a method implemented by a processor for the movement of containers of semi-finished products and the related apparatus suitable to ensure a high level of reliability over time and also to be easily and economically constructed.

These are other purposes are achieved by the method implemented by a processor for the movement of containers of semi-finished products and the related apparatus according to the main claims. The constructive and functional characteristics of the method implemented by a processor for the movement of containers of semi-finished products and the related apparatus, covered by this invention will be better illustrated during the detailed description that follows, in which reference is made to the accompanying drawings that represent a preferred and non-limiting embodiment and in which:
Figure 1 is a schematic representation of the flow chart of the method implemented by a processor for the movement of containers of semi-finished products covered by the invention;
Figure 2 is a schematic and axonometric representation of the apparatus for movement containers of semi-finished products implementing the method covered by the invention.

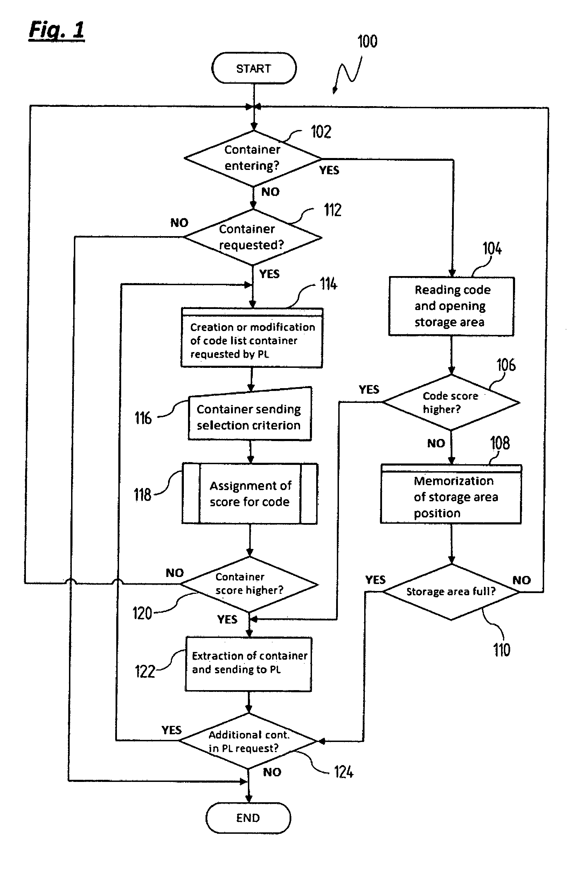

With initial and particular reference to Figure 1, the method implemented by a processor for the movement of containers of semi-finished products, indicated as a whole with 100, comprises the following steps:
- checking containers 102 entering the storage area;
- code reading 104 and opening the storage area;
- first check 106 of the score of the container code that is higher than the others;
- storage 108 of the position and of the storage area of disposition of the container;
- availability check 110 of the storage area;
- checking containers being requested 112 by the workstations PL;
- selection criterion 116 for sending containers;
- assignment of a score 118 for each container code.
- second check 120 of the score of the container code that is higher than the others;
- extracting container 122 and sending to the requesting workstation PL;
- checking containers being requested 124 by the workstations PL. The method of this invention, implemented by a processor or computer, is based on the optional choice by the operators or the manager of the production plant of priority selection criteria of the containers from the storage area. These criteria can be established and programmed without numerical constraints. The criteria selected and entered in a list have a decreasing priority from the first to the last, in function of which a score is assigned to a container. The criterion selected in order of priority gives a higher score to some containers with respect to others.

The preferential selection criteria for a box to be sent to the workstations PL can follow these operating logics of the production plant:
- Balancing operations: preferentially selects the containers to be sent seeking to ensure the best possible balance between the quantity of containers present and the number of places assigned to each operation;
- Balancing production: preferentially selects the containers to be sent seeking to ensure the daily production quantity set for each article;
- Grouping: preferentially selects the containers to be sent grouping them with relation to a customer code;
- Processing time: preferentially selects the containers to be sent choosing those in processing for the longest time;
- Priority level: preferentially selects the containers to be sent as a function of a value set in a field of the container archive;
- Thread colour conformity: preferentially selects the containers seeking to send to the workstation a container containing semi-finished items having the same colour and diameter of the stitching yarn of the last container previously sent, in order to avoid having the operator change colour/section of the thread;
- Article conformity: preferentially selects containers seeking to send to the workstations containers all having the same article as the last container previously sent;
- Operation conformity: preferentially selects containers seeking to send to the workstations containers having the articles that need the same operation as the last container previously sent;
- Size conformity: preferentially selects containers seeking to send to the workstations containers containing articles having a size corresponding to those of the last container previously sent;
- Preferential operators: preferentially selects containers seeking to send to the workstations containers containing articles related to a preferential operation of the operator with a higher yield;
- Delivery date: preferentially selects containers seeking to send to the workstations containers containing articles having the nearest required end of processing date;
- Stock operations: preferentially selects the containers to be sent to the workstations by analysing the quantity of containers present in the storage area or areas related to each operation, giving priority to the operation for which a higher number of containers is available;

The control unit of the plant, as a function of the selected criteria, or a list of selected criteria, gives a score to each container in the storage area. The control unit will, therefore, command the extraction from the warehouse of boxes in order of the highest score, making flow to the workstations PL, by means of movement devices, the containers related to the articles selected according to criteria of priority.

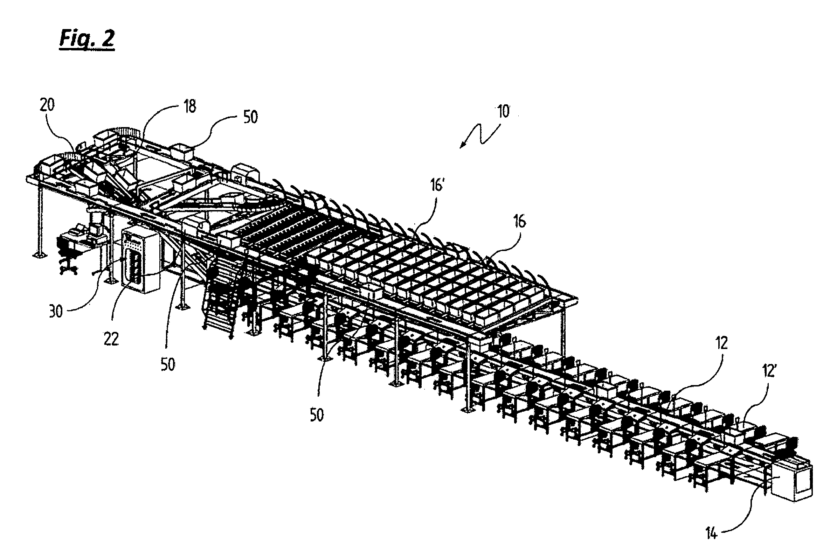

Said method is suitable to be implemented on a processor or computer by means of an algorithm composed of portions of code contained on conventional media readable by the same processor. With particular reference to Figure 2, the apparatus for movement contains of semi-finished products implementing the method covered by the invention indicated with 10, in a general embodiment, comprises:
- at least one processing line 12 with a plurality of workstations 12';
- first movement means 14 of containers 50 placed along said processing line 12;
- at least one storage area 16 with a multiplicity of positions 16' suitable for storing said containers 50;
- second movement means 18 of said containers 50 from said line 12 to said storage area 16;
- third movement means 20 of said containers 50 from said storage area 16 to said processing line 12;
- a control unit 30 comprising a PLC and a processor.
- detection and recognition means 22 of the containers 50.

Said first movement means 14 of containers 50 are generally motorized conveyor belts managed by the control unit.

Said second and third movement means 18 and 20 of said containers 50 from said processing line 12 to said storage area 16 and vice versa, are generally of motorized devices with motorized conveyor with belts with ramps, slides and rollers also provided with sensors and position transducers, or can also be column elevators.

Said detecting and recognition means 22 of the containers 50 generally comprise optical or electromagnetic systems for reading bar codes or the like.

From the description of the method 100, implemented by a processor for the movement of containers of semi-finished products covered by the invention, one can understand its operation described below with reference to the related apparatus 10 that implements it.

With primary reference to the diagram of Figure 2 and to the flow diagram of Figure 1, the apparatus 10 is provided with a processing line 12 with a plurality of workstations 12' suitable to simultaneously perform different types of processing on different basic semi-finished products. The semi-finished products are brought to the workstations 12' thanks to the movement means 14 of the processing line 12. All types of semi-finished products following the various different processes are arranged in the containers 50 and sent without any order, through the return of the processing line 12, to the second movement means 18 that conduct the containers 50 to the storage area 16 raised with respect to the processing line 12.

At the entrance of the storage area, the containers 50 are identified by the detection and recognition means 22 and sent by the control unit 30 to a defined fixed or mobile storage area 16, until all the locations are filled, or again on the processing line 12, if the score attributed to the container 50 is higher than those already in the storage area 16. When the system determines that one or more stations 12' do not have a container 50 in reserve (beyond that being processed), the control unit 30 commands the sending of additional containers 50 to the workstations 12' generating a list of codes of containers 50 being requested. This list is ordered according to the criterion or criteria for sending containers previously set, such as, for example, in of delivery date and processing time. The control unit 30 attributes a higher score to the containers 50 related to semi-finished products or articles that have a closer delivery deadline and that are in processing for a longer time. The containers 50 present in the storage area with a higher score are therefore extracted from the storage area 16, regardless of the position occupied, and sent through the third moving means 20 on the processing line 12 to the requesting processing stations 12'.

When the containers 50 having a lower score are logistically disposed in order of extraction ahead of containers 50 having a higher score, those with lower score are recirculated into the storage area 16 in such a way as to make immediately available on the processing line 12 the containers with a higher score, when they are required by the workstations 12'.

As can be seen from the foregoing, the advantages of the method implemented by a processor for the movement of containers of semi-finished products and related apparatus covered by this invention are evident.

The method implemented by a processor for the movement of containers of semi-finished products and related apparatus are particularly advantageous for the fact of allowing a substantial reduction of the movement time of semi-finished products in the production plant, significantly increasing productivity.

A further advantage of the method implemented by a processor for the movement of containers of semi-finished products and the related apparatus consists in the fact of making immediately available on the processing line 12, the containers 50 containing the semi-finished products required by the processing in progress without idle recirculation of containers on the processing line 12 itself.

The method implemented by a processor for the movement of containers of semi-finished products is shown to be additionally advantageous due to the fact of allowing the control of the processing times of each workstation and comparing them with standard times, in such a way as to determine the operating yield of each container and each operator.

Still more advantageous for the method implemented by a processor for the movement of containers of semi-finished products is the fact of being easily integratable and implementable in existing production plants.

Although the invention has been described with particular reference to a preferred embodiment, provided only by way of non-limiting example, many modifications and variations will be apparent to a person skilled in the art in light of the above description. Therefore, this invention intends to embrace all the modifications and variants falling within the spirit and scope of the following claims.

## Claims

1. A method (100) for the movement of containers of semi-finished products on automated systems comprising the steps of:
- checking containers (102) entering the storage area;
- code reading (104) and opening the storage area;
- storage (108) of the position and of the storage area of disposition of the container;
- availability check (110) of the storage area;
- checking containers being requested (112) by the workstations PL;
- extracting container (122) and sending to the requesting workstation PL;
- checking further containers being requested (124) by the workstations PL;
**characterized in that** it comprises the steps of:
- selection criterion (116) for sending containers;
- assignment of a score (118) of the container code;
- one or more checking steps (106, 120) of the score of the container code that is higher than the others.

2. The method (100) according to claim 1, **characterized in that** said first step of checking (106) the score of the container code that is higher than the others is carried out on containers entering the storage area and requested by the workstations.

3. The method (100) according to claim 1, **characterized in that** said second step of checking (120) the score of the container code that is higher than the others is carried out on containers present in the storage area.

4. The method (100) according to claim 1, **characterized in that** said step of selection criterion (116) for sending containers includes a plurality of criteria independently selectable from a list and having decreasing priority from first to last.

5. The method (100) according to claim 1, **characterized in that** said step of assigning a score (118) of the container code gives a higher score to the first criterion and a descending score to the next ones.

6. An algorithm or computer program comprising portions of code that, when executed by said computer, are suitable to implement a method according to any of the preceding claims.

7. Computer-readable media containing portions of code that, when executed by said computer, allow implementing all the steps of the method according to any of claims 1 to 5.

8. An apparatus (10) for the movement of containers suitable to implement the method (100) according to claim 1, comprising:
- at least one processing line (12) with a plurality of workstations (12)';
- first movement means (14) of containers (50) placed along said processing line (12);
- at least one storage area (16) with a multiplicity of positions (16') suitable for storing said containers (50);
- second movement means (18) of said containers (50) from said line (12) to said storage area (16);
- third movement means (20) of said containers (50) from said storage area (16) to said processing line (12);
**characterized in that** it comprises a control unit (30) comprising at least one PLC and a processor, and detection and recognition means (22) of the containers (50).

9. The apparatus (10) according to claim 8, **characterized in that** said first movement means (14) comprise motorized conveyor belts managed by the control unit (30).

10. The apparatus (10) according to claim 8, **characterized in that** said second and third movement means (18, 20) comprise motorized ramp conveyor belts, conveyors, slides or column elevators managed by the control unit (30).

11. The apparatus (10) according to claim 8, **characterized in that** said and third movement means (18, 20) comprise position transducers and sensors managed by the control unit (30).

12. The apparatus (10) according to claim 8, **characterized in that** said detection and recognition means (22) of the containers (50) comprise optical or electromagnetic reading systems, or the like, managed by the control unit (30).
